# EUROPEAN PATENT SPECIFICATION

(11) **EP 4 498 431 B1**
(45) Date of publication and mention of the grant of the patent: **13.05.2026**
(21) Application number: 24185939.6
(22) Date of filing: 02.07.2024
(51) Int. Cl.: H01L 25/065, H01L 23/50, H01L 21/48, H01L 23/48, H01L 23/498, H01L 23/538, H01L 25/04, H01L 23/00, H01L 25/18

(54) **SEMICONDUCTOR PACKAGE STRUCTURE**
HALBLEITERGEHÄUSESTRUKTUR
STRUCTURE DE BOÎTIER DE SEMI-CONDUCTEUR

(30) Priority: 28.07.2023 US 202363516179 P; 06.06.2024 US 202418735973
(43) Date of publication of application: 29.01.2025
(73) Proprietor: MEDIATEK INC., Hsinchu City 30078 (TW)
(72) Inventor: FANG, Tzu-Jui, 30078 Hsinchu City (TW); HUNG, Jui-Pin, 30078 Hsinchu City (TW)
(74) Representative: Haseltine Lake Kempner LLP

(56) References cited:
- US-A1- 2009 215 231
- US-A1- 2020 091 063
- US-A1- 2020 176 417
- US-A1- 2021 098 323
- US-A1- 2022 007 511
- US-A1- 2022 336 336
- US-A1- 2023 062 775

## Description

### BACKGROUND OF THE INVENTION

### Field of the Invention

The present invention relates to semiconductor technology, and, in particular, to a semiconductor package structure that includes a capacitor.

### Description of the Related Art

In addition to providing a semiconductor die with protection from environmental contaminants, a semiconductor package structure can also provide an electrical connection between the semiconductor die packaged inside it and a substrate such as a printed circuit board (PCB).

Although existing semiconductor package structures generally meet requirements, they have not been satisfactory in all respects. For example, more and more metal layers in the package substrate are needed to meet demands for high electrical signal performance. However, as the size of semiconductor package structures becomes larger, package substrate warpage becomes a critical issue. Therefore, further improvements in semiconductor package structures are required.
Reference may be made to the following documents:
US 2022 / 336336 A1 which relates to a semiconductor package and method of fabricating the same;
US 2020 / 091063 A1 which relates to a semiconductor structure, package structure, and manufacturing method thereof;
US 2022 / 007511 A1 which relates to an electronic component-embedded substrate;
US 2009 / 215231 A1 which relates to a method of manufacturing an electronic component built-in substrate;
US 2021 / 098323 A1 which relates to an integrated circuit package and method;
US 2023 / 062775 A1 which relates to a package substrate, package using the same, and method of manufacturing the same; and
US 2020 / 176417 A1 which relates to a stacked embedded passive substrate structure.

### BRIEF SUMMARY OF THE INVENTION

The present invention is defined by the appended claims. Semiconductor package structures are provided. An exemplary embodiment of a semiconductor package structure includes a package substrate and a semiconductor die.
The package substrate includes a core structure, an integrated capacitor structure, and a redistribution layer. The integrated capacitor structure is embedded in the core structure. The redistribution layer is disposed over the integrated capacitor structure. The semiconductor die is disposed over the package substrate and is thermally coupled to the integrated capacitor structure through the redistribution layer.

Another embodiment of a semiconductor package structure includes a package substrate. The package substrate includes a core structure, a first capacitor, a second capacitor, a first insulating filler, a first redistribution layer, and a second redistribution layer. The first capacitor and the second capacitor are stacked vertically and are embedded in the core structure. The first insulating filler is disposed in the core structure and surrounds the first capacitor and the second capacitor. The first redistribution layer is disposed below the core structure. The second redistribution layer is disposed over the core structure and is electrically coupled to the first capacitor and the second capacitor.

### BRIEF DESCRIPTION OF THE DRAWINGS

The present invention can be more fully understood by reading the subsequent detailed description and examples with references made to the accompanying drawings, wherein:
FIGs. 1A to 1E are cross-sectional views of various stages of manufacturing an exemplary semiconductor package structure in accordance with some embodiments of the present disclosure;
FIGs. 2A to 2C are cross-sectional views of various stages of manufacturing an exemplary semiconductor package structure in accordance with some embodiments of the present disclosure;
FIG. 3 is a cross-sectional view of an exemplary semiconductor package structure in accordance with some embodiments of the present disclosure;
FIG. 4 is a cross-sectional view of an exemplary semiconductor package structure in accordance with some embodiments of the present disclosure;
FIG. 5 is a cross-sectional view of an exemplary semiconductor package structure in accordance with some embodiments of the present disclosure;
FIG. 6 is a cross-sectional view of an exemplary semiconductor package structure in accordance with some embodiments of the present disclosure;
FIG. 7 is a cross-sectional view of an exemplary semiconductor package structure in accordance with some embodiments of the present disclosure; and
FIG. 8 is a cross-sectional view of an exemplary semiconductor package structure in accordance with some embodiments of the present disclosure.

### DETAILED DESCRIPTION OF THE INVENTION

The following description is made for the purpose of illustrating the general principles of the invention and should not be taken in a limiting sense. The scope of the invention is best determined by reference to the appended claims.

The present disclosure will be described with respect to particular embodiments and with reference to certain drawings, but the disclosure is not limited thereto and is only limited by the claims. The drawings described are only schematic and are non-limiting. In the drawings, the size of some of the elements may be exaggerated for illustrative purposes and not drawn to scale. The dimensions and the relative dimensions do not correspond to actual dimensions in the practice of the disclosure.

Additional elements may be added on the basis of the embodiments described below. For example, the description of "a first element on/over a second element" may include embodiments in which the first element is in direct contact with the second element, and may also include embodiments in which additional elements are disposed between the first element and the second element such that the first element and the second element are not in direct contact.

Furthermore, the description of "a first element extending through a second element" may include embodiments in which the first element is disposed in the second element and extends from a side of the second element to an opposite side of the second element, wherein a surface of the first element may be substantially leveled with a surface of the second element, or a surface of the first element may be outside a surface of the second element.

The spatially relative descriptors of the first element and the second element may change as the structure is operated or used in different orientations. In addition, the present disclosure may repeat reference numerals and/or letters in the various embodiments. This repetition is for simplicity and clarity and does not in itself dictate a relationship between the various embodiments discussed.

In semiconductor packages, such as a laptop central processing unit (CPU) package structure, a silicon capacitor embedded in a substrate may be adopted for decoupling performance enhancement. However, the embedded solution is limited to thin core structure due to the thickness of the silicon capacitor. If the core structure which is not thick enough, the package substrate warpage may occur, and the warpage may become severe as the size of the package substrate increases.

In view of this, a semiconductor package structure including an integrated capacitor structure is described in accordance with some embodiments of the present disclosure. The integrated capacitor structure including stacked capacitors is embedded in a core structure. As such, the thickness of the core structure can be increased to fulfill requirement of large size of the package substrate.

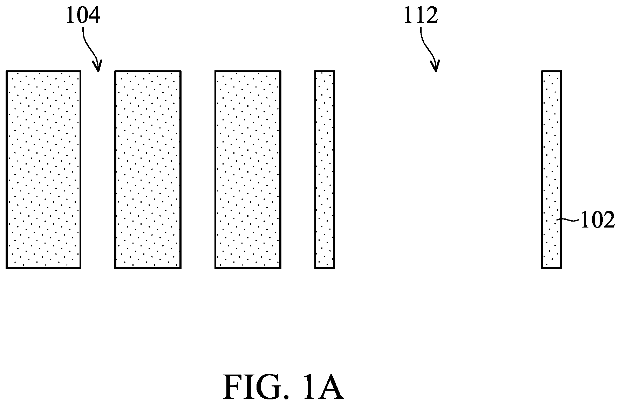

FIGs. 1A to 1E are cross-sectional views of various stages of manufacturing a semiconductor package structure 100 in accordance with some embodiments of the present disclosure. Additional features can be added to the semiconductor package structure 100. Some of the features described below can be replaced or eliminated for different embodiments. To simplify the diagram, only a portion of the semiconductor package structure 100 is illustrated.

As illustrated in FIG. 1A, a core structure 102 is provided, in accordance with some embodiments. The core structure 102 may be formed of an organic material, a glass material, a ceramic material, a semiconductor material, the like, or a combination thereof. The organic material may include fiberglass resin (e.g., FR4), bismaleimide triazine (BT) resin, the like, or a combination thereof. The semiconductor material may include silicon, germanium, or a compound material, including silicon germanium, silicon carbide, gallium arsenic, silicon germanium carbide, the like, or a combination thereof.

Then, a plurality of openings 104 and a cavity 112 are formed in the core structure 102, in accordance with some embodiments. The openings 104 and the cavity 112 may be formed through the core structure 102 by laser drilling or any suitable methods. According to some embodiments, the openings 104 and the cavity 112 are formed simultaneously.

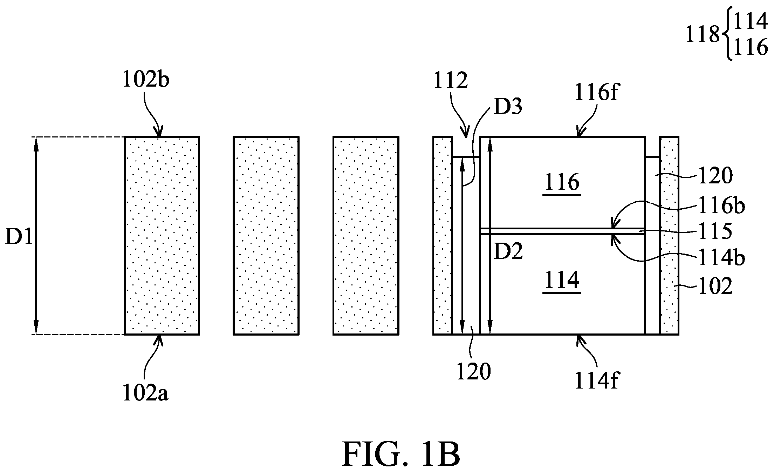

Afterwards, as shown in FIG. 1B, an integrated capacitor structure 118 is disposed in the cavity 112, in accordance with some embodiments. The integrated capacitor structure 118 is embedded in the core structure 102. The integrated capacitor structure 118 includes two capacitors 114 and 116 which are stacked vertically. That is, the capacitors 114 and 116 may be stacked in the direction vertical to the bottom surface of the core structure 102.

The capacitors 114 and 116 may include silicon capacitors. The thickness D1 of the core structure 102 may be substantially equal to the thickness D2 of the integrated capacitor structure 118. Since the thickness D2 of the embedded integrated capacitor structure 118 is greater than the thickness of any one of capacitors 114 and 116, the thickness D1 of the core structure 102 can be increased. As a result, the warpage of the package substrate can be reduced. Decoupling performance enhancement can be achieved as well.

In some embodiments, the thickness D2 of the integrated capacitor structure 118 is in a range of about 0.8 mm to about 1.4 mm, such as about 1.0 mm. The thickness D1 of the core structure 102 may be in a range of about 0.8 mm to about 1.4 mm, such as about 1.0 mm.

The capacitors 114 and 116 may be assembled back-to-back. In particular, the backside surface 114b of the capacitor 114 may face the backside surface 116b of the capacitor 116. The frontside surface 114f of the capacitor 114 may be substantially aligned with the bottom surface 102a of the core structure 112, and the frontside surface 116f of the capacitor 116 may be substantially aligned with a top surface 102b of the core structure 112. This allows subsequent layers (such as a redistribution layer) to be formed on flat surfaces.

The capacitors 114 and 116 may be bonded using an adhesive layer 115. The adhesive layer 115 may be a die attach film or any suitable materials. Alternatively, the capacitors 114 and 116 may be bonded using fusion bonding, hybrid bonding, or any suitable methods. Fusion bonding may include dielectric-to-dielectric bonding and/or conductor-to-conductor bonding. Hybrid bonding may be a combination of dielectric-to-dielectric bonding and conductor-to-conductor bonding, which may be metal-to-metal direct bonding, such as copper-to-copper direct bonding. When hybrid bonding or metal-to-metal bonding is utilized, the thermal dissipation efficiency may be further enhanced compared to dielectric-to-dielectric bonding or die attach film.

One or more active and passive devices (not shown) may also be disposed in the core structure 102 for the structural and functional requirements of the design. For example, the active and passive devices may include transistors, capacitors, resistors, the like, or a combination thereof.

Then, an insulating filler 120 is formed in the cavity 112 to secure the integrated capacitor structure 118, in accordance with some embodiments. The insulating filler 112 may be formed by filling an insulating material, such as resin, in the space between the cavity 112 and the integrated capacitor structure 118.

Due to the properties of the insulating filler 120, the thickness D3 of the insulating filler 120 may be equal to or less than 0.6 mm. Therefore, the top surface of the insulating filler 112 may be lower the top surface 102b of the core structure 102. The thickness D3 of the insulating filler 120 is less than the thickness D1 of the core structure 102 and is less than the thickness D2 of the integrated capacitor structure 118. That is, the insulating filler 120 surrounds the bottom portion of the integrated capacitor structure 118 and exposes the top portion of the integrated capacitor structure 118.

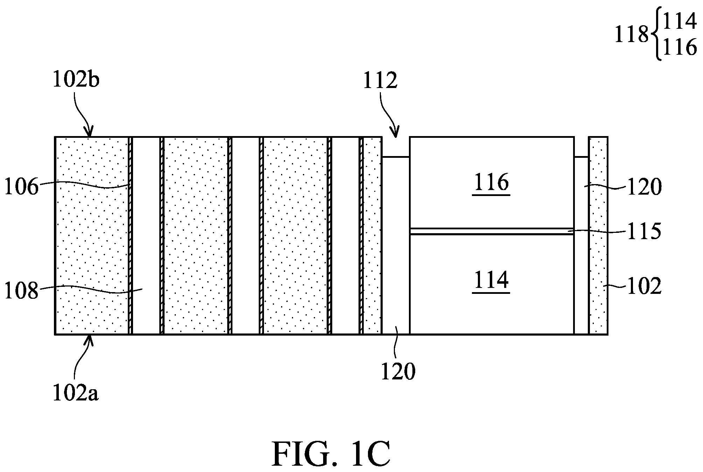

Then, as shown in FIG. 1C, a plurality of through vias 106 are formed on sidewalls of the openings 104, in accordance with some embodiments. The through vias 106 may be formed by plating at least sidewalls of the openings 104 with metal, including copper, silver, gold, the like, an alloy thereof, or a combination thereof.

Afterwards, an insulating filler 108 is formed in each of the through vias 106, in accordance with some embodiments. The insulating filler 108 may be formed by filling an insulating material, such as resin, in the space surrounded by the through vias 106. Then, grinding may be performed to remove excess insulating material to form a flat surface. The bottom surface of the insulating filler 108 and the bottom surface of the insulating filler 112 may be substantially coplanar with the bottom surface 102a of the core structure 102.

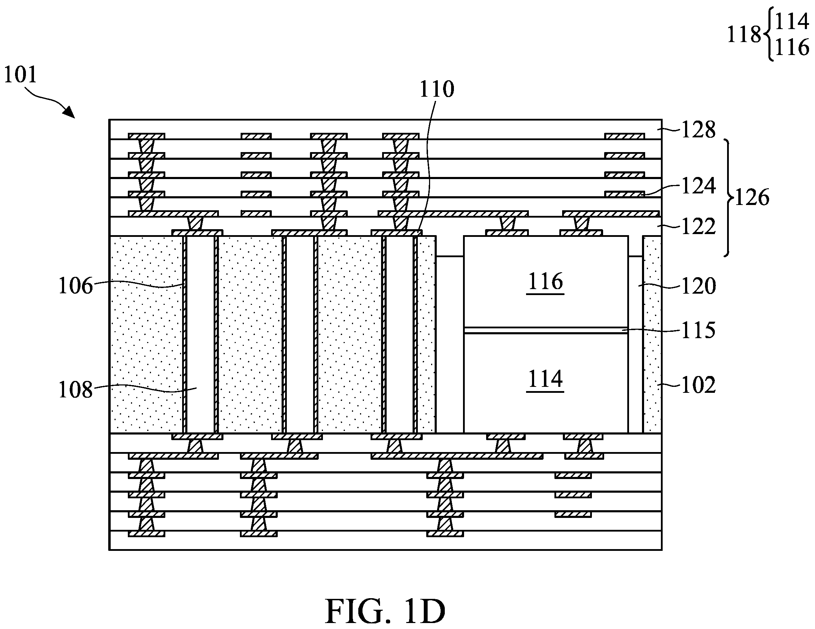

Afterwards, as shown in FIG. 1D, a plurality of metal layers 110 are formed on opposite surfaces of the insulating fillers 108 and the integrated capacitor structure 118 by plating or any suitable methods, in accordance with some embodiments. The metal layers 110 may be formed of a material similar to that of the through vias 106, including copper, silver, gold, the like, an alloy thereof, or a combination thereof.

Then, dielectric layers 122 are filled in the space remaining in the cavity 112, in accordance with some embodiments. The dielectric layers 122 surrounds the top portion of the integrated capacitor structure 118 and is in contact with the insulating filler 120. The dielectric layers 122 may be a build-up film, and may be formed of dielectric material, including Ajinomoto build-up film (ABF) or another suitable material. The dielectric layers 122 may be formed by a lamination process, a coating process, or another suitable process.

Additional dielectric layers 122 may be formed on opposite surfaces of the core structure 102 and may be patterned to form openings (not illustrated) therein. The openings may be through holes or trenches. Then, routing layers 124 may be formed in the openings. The routing layers 124 may include horizontal interconnects, such as conductive layers or conductive pads, and vertical interconnects, such as conductive vias. The conductive vias may electrically couple different levels of the conductive layers and the conductive pads. The routing layers 124 may be formed by plating or any suitable methods. The routing layers 124 may be formed of a material similar to that of the through vias 106, including copper, silver, gold, the like, an alloy thereof, or a combination thereof.

The routing layers 124 may be electrically coupled to the through vias 106 and the integrated capacitor structure 118. The dielectric layers 122 and the routing layers 124 are referred to as a redistribution layer 126. The redistribution layer 126 on opposite surfaces of the core structure 102 may be electrically coupled to each other through the through vias 106.

Then, a solder resist 128 is formed over the dielectric layers 122 to protect the redistribution layer from external damage, in accordance with some embodiments. A package substrate 101 is formed.

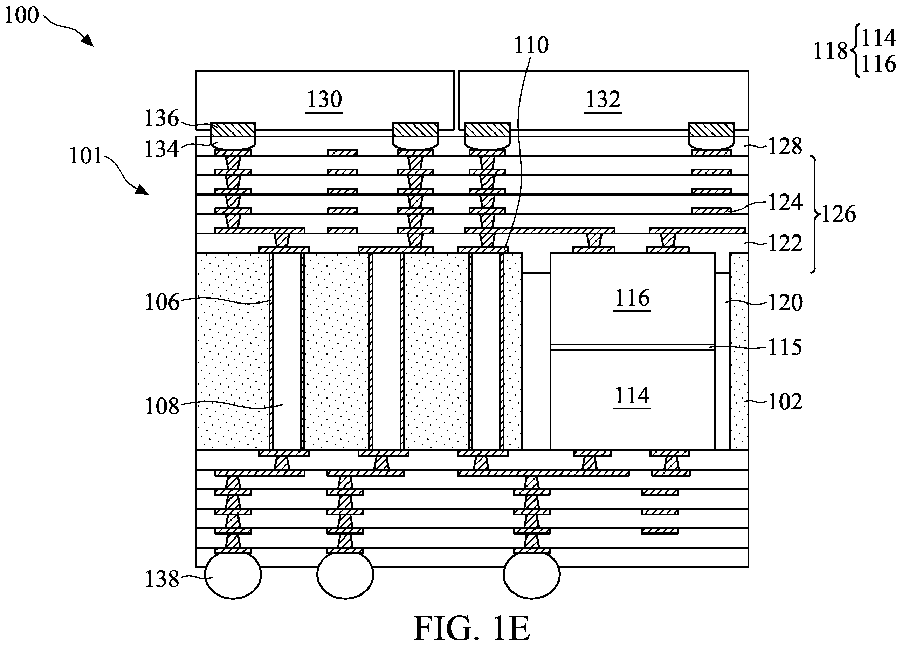

Afterwards, as illustrated in FIG. 1E, a plurality of openings may be formed in the solder resist 128 by a lithography process or any suitable methods to expose the conductive pads of the routing layers 124. Then, a plurality of solder connectors 134 may be formed in the openings and may be in contact with the conductive pads of the routing layers 124. The solder connectors 134 may include solder balls or other conductive connectors. The solder connectors 134 may be placed in a grid array of rows and columns by a printing process or any suitable methods.

Afterwards, semiconductor dies 130 and 132 are disposed over the package substrate 101, in accordance with some embodiments. A plurality of conductive connectors 136 may be formed below the semiconductor dies 130 and 132 to connect the solder connectors 134. The semiconductor dies 130 and 132 may be electrically coupled to the routing layers 124 through the solder connectors 134 and the conductive connectors 136.

The conductive connectors 136 may include microbumps, controlled collapse chip connection (C4) bumps, conductive pillars, the like, or a combination thereof. The conductive connectors 136 may be formed of metal, such as tungsten, titanium, tantalum, ruthenium, cobalt, copper, aluminum, platinum, tin, silver, gold, the like, an alloy thereof, or a combination thereof.

In some embodiments, the semiconductor dies 130 and 132 each independently includes a system-on-chip (SoC) die, a logic device, a memory device, a radio frequency (RF) device, the like, or a combination thereof. For example, the semiconductor dies 130 and 132 may include a micro control unit (MCU) die, a microprocessor unit (MPU) die, a power management integrated circuit (PMIC) die, a radio frequency front end (RFFE) die, an accelerated processing unit (APU) die, a central processing unit (CPU) die, a graphics processing unit (GPU) die, an input-output (IO) die, a dynamic random access memory (DRAM) controller, a static random-access memory (SRAM), a high bandwidth memory (HBM), an application processor (AP) die, an application specific integrated circuit (ASIC) die, the like, or a combination thereof.

The integrated capacitor structure 118 may be electrically coupled to the semiconductor die 130 and/or semiconductor die 132 through the routing layer 124 and through vias 108. The integrated capacitor structure 118 may be placed closer to the semiconductor die that needs more power to prevent voltage drop, such as the semiconductor die 132. In other words, the integrated capacitor structure 118 may be placed directly under the semiconductor die 130 or the semiconductor die 132. For example, as shown in FIG. 1E, the semiconductor die 132 may vertically overlap the integrated capacitor structure 118.

It should be noted that the two semiconductor dies 130 and 132 are for illustrative purposes only, and more semiconductor dies may be disposed over the package substrate 101. In addition, one or more passive components (such as resistors, capacitors, or inductors) may also be disposed over the package substrate 101.

A plurality of conductive terminals 138 are disposed on the surface of the package substrate 101 opposite to the semiconductor dies 130 and 132, in accordance with some embodiments. A semiconductor package structure 100 is formed. The conductive terminals 138 may include microbumps, controlled collapse chip connection (C4) bumps, solder balls, ball grid array (BGA) balls, the like, or a combination thereof. The conductive terminals 138 may be formed of metal, such as tungsten, titanium, tantalum, ruthenium, cobalt, copper, aluminum, platinum, tin, silver, gold, the like, an alloy thereof, or a combination thereof. The conductive terminals 138 may be electrically coupled to the routing layers 124.

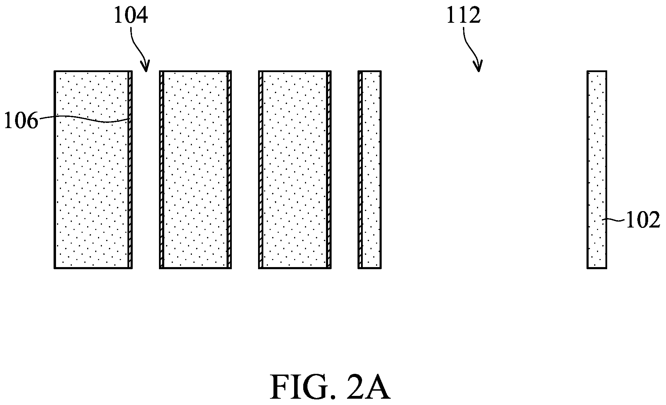

FIGs. 2A to 2C are cross-sectional views of various stages of manufacturing a semiconductor package structure in accordance with some embodiments of the present disclosure. FIG. 2A is subsequent to the step of the process that is illustrated in FIG. 1A, and the same or similar reference numbers are used to depict the same or similar components as those of the semiconductor package structure 100, so for the sake of simplicity, those components will not be discussed in detail again. In the following embodiments, process sequence is adjusted.

As illustrated in FIG. 2A, after forming the openings 104 and the cavity 112, a plurality of through vias 106 are formed on sidewalls of the openings 104, in accordance with some embodiments.

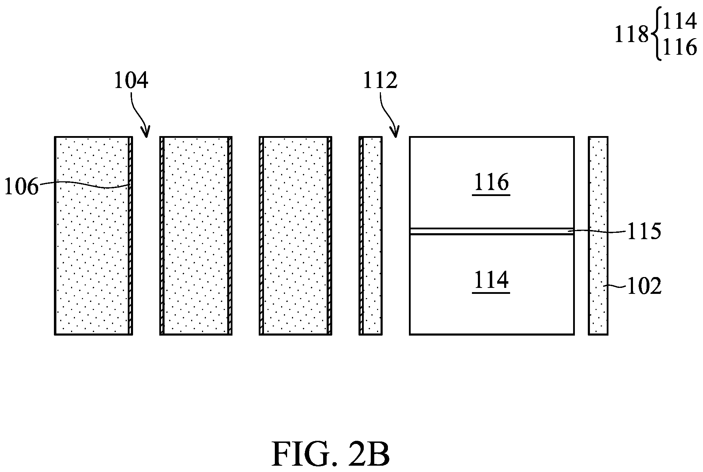

Then, as shown in FIG. 2B, an integrated capacitor structure 118 is disposed in the cavity 112, in accordance with some embodiments.

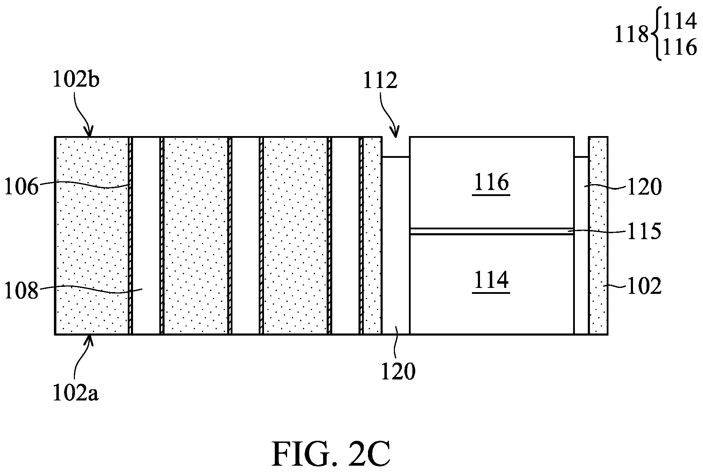

Afterwards, as illustrated in FIG. 2C, an insulating filler 108 is formed in each of the through vias 106 and an insulating filler 120 is formed in the cavity 112, in accordance with some embodiments. Then, grinding may be performed to remove excess insulating material to form a flat surface. Then, the processes described with reference to FIGs. 1D and 1E may be performed to continue manufacturing the semiconductor package structure. These process sequences are examples only, and other process sequences are possible.

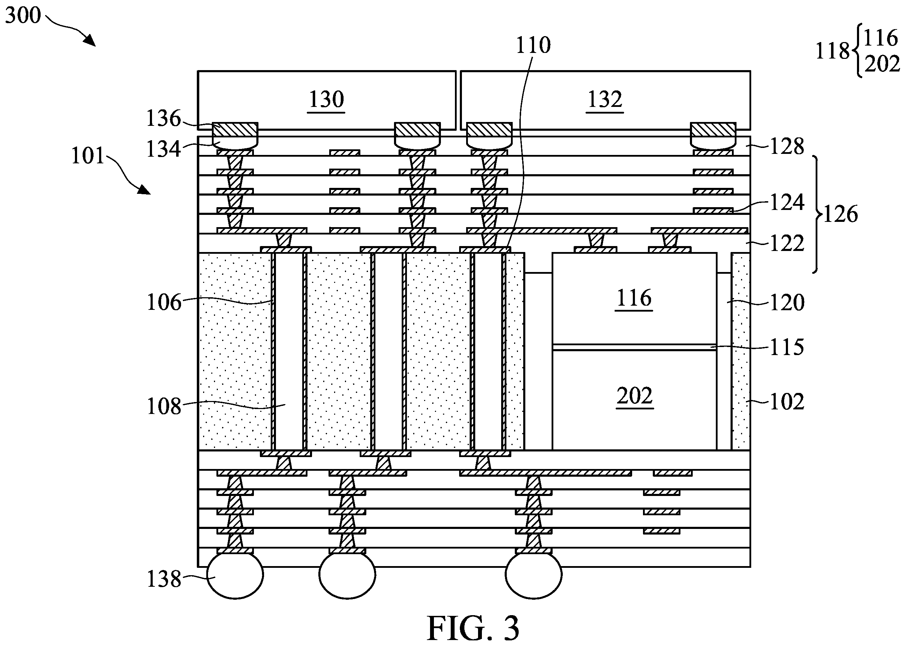

FIG. 3 is a cross-sectional view of a semiconductor package structure 300 in accordance with some embodiments of the present disclosure. It should be noted that the semiconductor package structure 300 may include the same or similar components as that of the semiconductor package structure 100, which is illustrated in FIG. 1E, and for the sake of simplicity, those components will not be discussed in detail again. In the following embodiments, an integrated capacitor structure includes a dummy die.

As illustrated in FIG. 3, the integrated capacitor structure 118 includes a dummy die 202 and a capacitor 116 stacked vertically, in accordance with some embodiments. The dummy die 202 and the capacitor 116 may be bonded using an adhesive layer 115 or by fusion bonding, hybrid bonding, or any suitable methods. By including the dummy die 202, the thickness of the embedded integrated capacitor structure 118 can be increased, so that the thickness of the core structure 102 can be increased. Therefore, the warpage of the package substrate 101 can be reduced.

The thickness and width of the dummy die 202 and the thickness and width of the capacitor 116 may be substantially the same as illustrated, or may be different. The thickness of the dummy die 202 may be adjusted according to the required thickness of the core substrate 102.

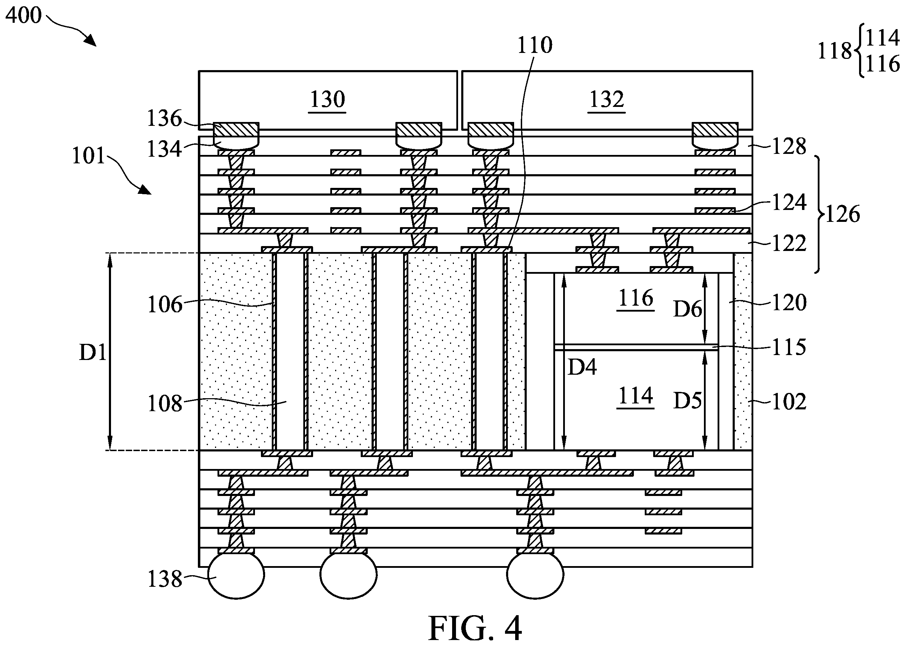

FIG. 4 is a cross-sectional view of a semiconductor package structure 400 in accordance with some embodiments of the present disclosure. It should be noted that the semiconductor package structure 400 may include the same or similar components as that of the semiconductor package structure 100, which is illustrated in FIG. 1E, and for the sake of simplicity, those components will not be discussed in detail again. In the following embodiments, a thickness of a core structure is greater than a thickness of an integrated capacitor structure.

As illustrated in FIG. 4, the thickness D1 of the core structure 102 may be further increased to be greater to the thickness D4 of the integrated capacitor structure 118. Therefore, the warpage of the package substrate 101 can be further reduced. The thickness D5 of the capacitor 114 and the thickness D6 of the capacitor 116 may be different as illustrated, or may be substantially the same. The dielectric layers 122 and the routing layers 124 may be formed over the integrated capacitor structure 118 and in the core structure 102.

The integrated capacitor structure 118 may include a dummy die, such as the capacitor 114 or the capacitor 116 may be replaced with a dummy die, similar to those described with reference to FIG. 3.

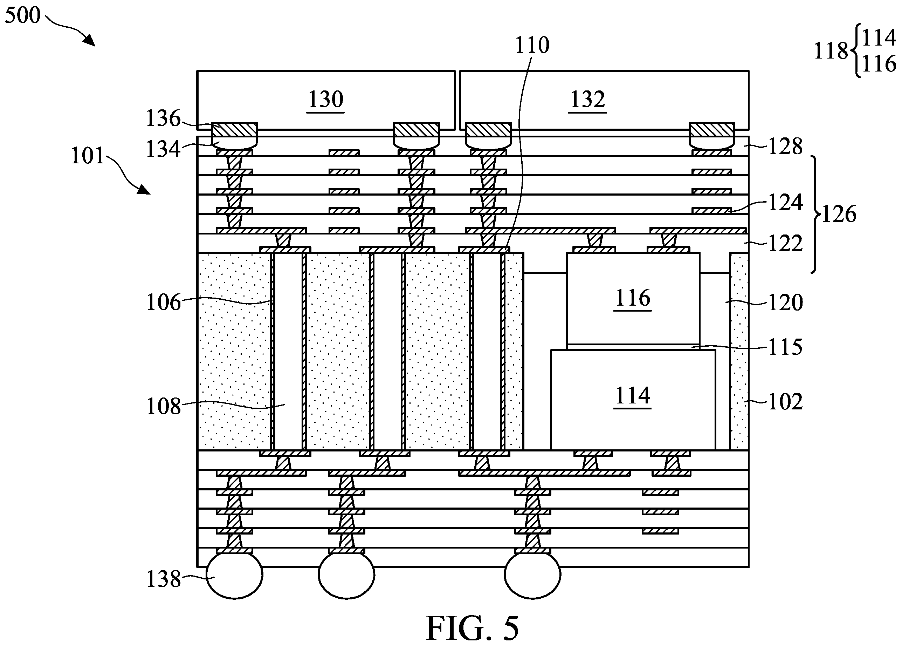

FIG. 5 is a cross-sectional view of a semiconductor package structure 500 in accordance with some embodiments of the present disclosure. It should be noted that the semiconductor package structure 500 may include the same or similar components as that of the semiconductor package structure 100, which is illustrated in FIG. 1E, and for the sake of simplicity, those components will not be discussed in detail again. In the following embodiments, an integrated capacitor structure includes capacitors which have different sizes.

As illustrated in FIG. 5, the integrated capacitor structure 118 includes two capacitors 114 and 116 which are stacked vertically and have different sizes, in accordance with some embodiments. The capacitors 114 and 116 may be bonded using an adhesive layer 115 or by fusion bonding, hybrid bonding, or any suitable methods. For example, a dimension (e.g., width) of the capacitor 114 may be greater than a dimension (e.g., width) of the capacitor 116. The insulating filler 120 may cover the top surface of the capacitor 114. The width of the adhesive layer 115 may be substantially equal to the width of the capacitor 116 and may be less than the width of the capacitor 114.

According to some embodiments, the thicknesses of the capacitors 114 and 116 are different as well, similar to those described with reference to FIG. 4.

The integrated capacitor structure 118 may include a dummy die, such as the capacitor 114 or the capacitor 116 may be replaced with a dummy die, similar to those described with reference to FIG. 3.

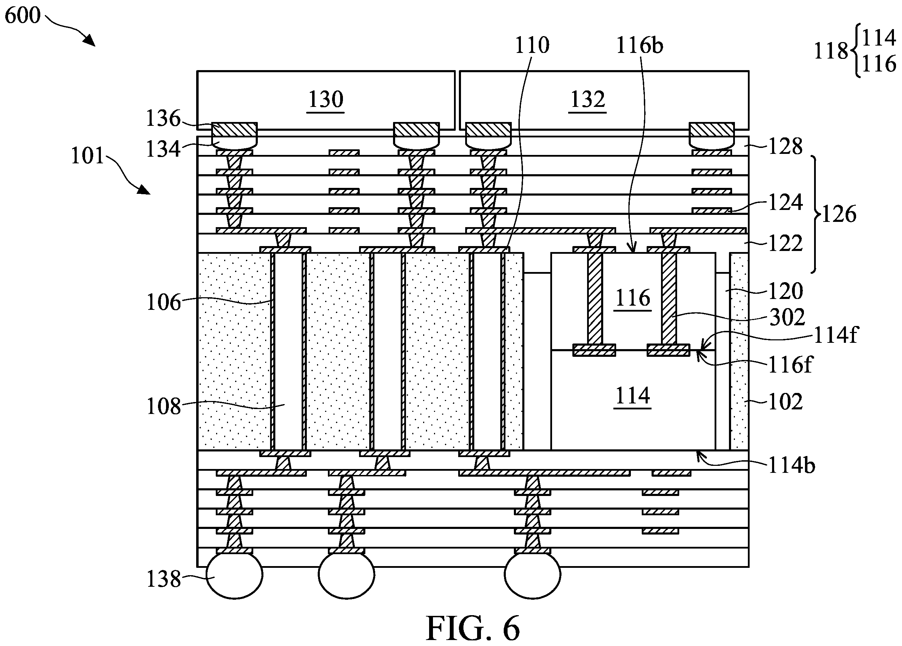

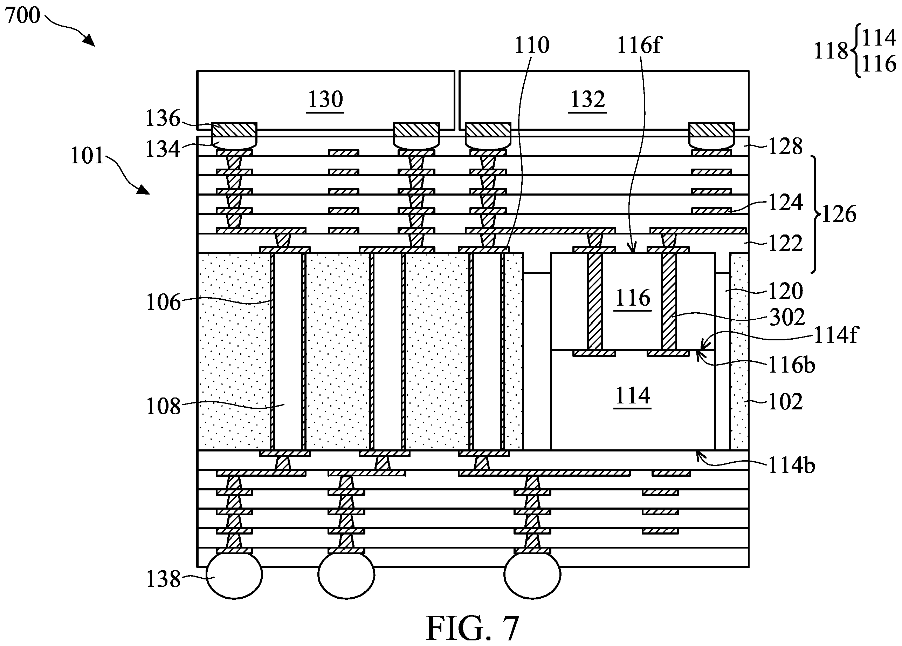

FIGs. 6 and 7 are cross-sectional views of semiconductor package structures 600 and 700 in accordance with some embodiments of the present disclosure. It should be noted that each of the semiconductor package structures 600 and 700 may include the same or similar components as that of the semiconductor package structure 100, which is illustrated in FIG. 1E, and for the sake of simplicity, those components will not be discussed in detail again. In the following embodiments, an integrated capacitor structure includes one or more through vias in a capacitor.

As shown in FIG. 6, an integrated capacitor structure 118 includes one or more through vias 302, in accordance with some embodiments. The through vias 302 may be disposed in the capacitor 116 and may be electrically coupled to the capacitor 114. The through vias 302 may be formed of metal, including tungsten, titanium, tantalum, ruthenium, cobalt, copper, aluminum, platinum, tin, silver, gold, the like, an alloy thereof, or a combination thereof. Therefore, the capacitors 114 and 116 may be assembled face-to-face or face-to-back. For example, as shown in FIG. 6, the frontside surface 114f of the capacitor 114 may be bonded to the frontside surface 116f of the capacitor 116. For another example, as shown in FIG. 7, the frontside surface 114f of the capacitor 114 may be bonded to the backside surface 116b of the capacitor 116.

The capacitors 114 and 116 may be bonded using fusion bonding, hybrid bonding, or any suitable methods. In some embodiments, the capacitors 114 and 116 are assembled face-to-face, and the capacitors 114 and 116 are electrically coupled to the semiconductor die 130 and/or the semiconductor die 132 through the through vias 302 and the routing layers 124, as shown in FIG. 6. In some other embodiments, the capacitors 114 and 116 are assembled face-to-back, the capacitor 114 is electrically coupled to the semiconductor die 130 and/or the semiconductor die 132 through the through vias 302 and the routing layers 124, and the capacitor 116 is electrically coupled to the semiconductor die 130 and/or the semiconductor die 132 through the routing layers 124, as shown in FIG. 7.

Although the sizes of the capacitors 114 and 116 are substantially the same as illustrated, the sizes of the capacitors 114 and 116 may be different, as those discussed in FIG. 5.

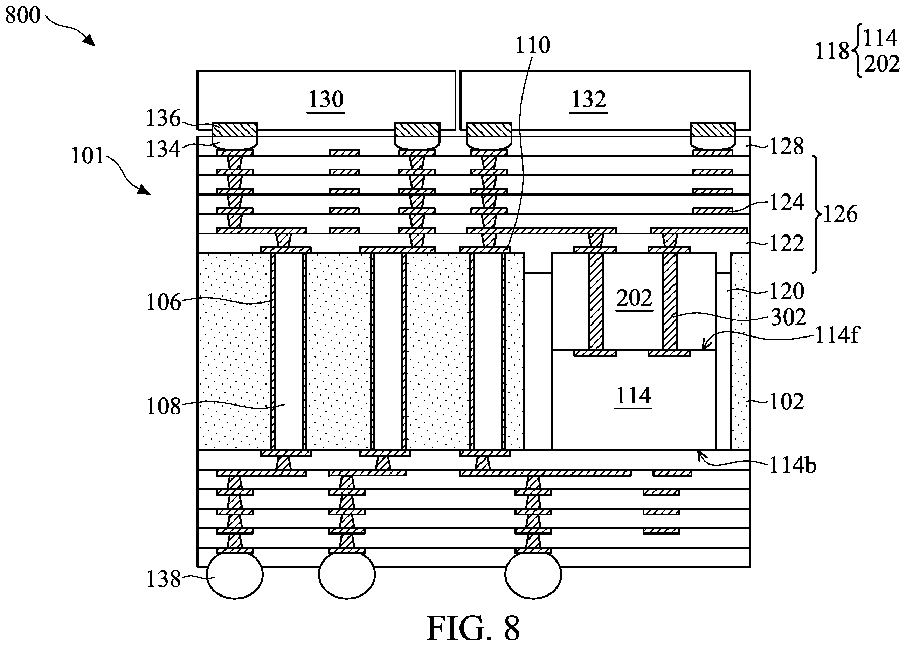

FIG. 8 is a cross-sectional view of a semiconductor package structure 800 in accordance with some embodiments of the present disclosure. It should be noted that the semiconductor package structure 800 may include the same or similar components as that of the semiconductor package structure 100, which is illustrated in FIG. 1E, and for the sake of simplicity, those components will not be discussed in detail again. In the following embodiments, an integrated capacitor structure includes a dummy die disposed over a capacitor.

As illustrated in FIG. 8, an integrated capacitor structure 118 includes a dummy die 202 disposed over a capacitor 114, in accordance with some embodiments. The capacitor 114 and the dummy die 202 may be bonded using fusion bonding, hybrid bonding, or any suitable methods. The integrated capacitor structure 118 may include one or more through vias 302 disposed in the dummy die 202 and electrically coupled to the capacitor 114. Therefore, the capacitor 114 may be electrically coupled to the semiconductor die 130 and/or the semiconductor die 132 through the through vias 302 and the routing layers 124.

In summary, the semiconductor package structure according to the present disclosure includes an integrated capacitor structure which is embedded in a core structure of a package substrate. The integrated capacitor structure includes stacked capacitors. Therefore, the thickness of the core structure can be increased, so that the warpage of the package substrate can be reduced. Furthermore, decoupling performance enhancement can be achieved.

## Claims

1. A semiconductor package structure (100, 300, 400, 500, 600, 700, 800), comprising:
a package substrate (101) comprising:
a core structure (102);
an integrated capacitor structure (118) embedded in the core structure (102); and
a redistribution layer (126) disposed over the integrated capacitor structure (118), the redistribution layer (126) comprising dielectric layers (122) and routing layers (124); and
a semiconductor die (130, 132) disposed over the package substrate (101) and electrically coupled to the integrated capacitor structure (118) through the redistribution layer (126);
wherein the integrated capacitor structure (118) comprises a first capacitor (114) and a second capacitor (116) which are stacked in a vertical direction relative to a bottom surface (102a) of the core structure (102);
wherein the package substrate (101) further comprises an insulating filler (120) disposed in the core structure (102) and surrounding a bottom portion the integrated capacitor structure (118) in the vertical direction;
**characterized in that** a thickness of the insulating filler (120) is less than a thickness of the core structure (102) and less than a thickness of the integrated capacitor structure (118) so as to expose a top portion of the integrated capacitor structure (118); and
wherein one of the dielectric layers (122) of the redistribution layer (126) surrounds the exposed top portion of the integrated capacitor structure (118) and is in contact with the insulating filler (120).

2. The semiconductor package structure (100) as claimed in claim 1, wherein a bottom surface of the integrated capacitor structure (118) is substantially aligned with the bottom surface (102a) of the core structure (102).

3. The semiconductor package structure (100) as claimed in claim 2, wherein a top surface of the integrated capacitor structure (118) is substantially aligned with a top surface (102b) of the core structure (102).

4. The semiconductor package structure (100) as claimed in claim 1, wherein the first capacitor (114) and the second capacitor (116) are assembled back-to-back and bonded using an adhesive layer (115), fusion bonding, or hybrid bonding.

5. The semiconductor package structure (100) as claimed in claim 4, wherein a dimension of the first capacitor (114) is greater than a dimension of the second capacitor (116).

6. The semiconductor package structure (100, 600, 700) as claimed in claim 1, wherein the second capacitor (116) is disposed over the first capacitor (114) and further comprising a through via electrically coupling the first capacitor (114) to the redistribution layer (126).

7. The semiconductor package structure (100, 600, 700) as claimed in claim 6, wherein the first capacitor (114) and the second capacitor (116) are bonded using fusion bonding or hybrid bonding.

8. The semiconductor package structure (100) as claimed in claim 1, wherein the package substrate (101) further comprises:
a second redistribution layer (126) disposed below the core structure (102); and
a through via extending through the core structure (102) and electrically coupling the redistribution layer (126) to the second redistribution layer (126).

9. The semiconductor package structure (100) as claimed in claim 1, wherein a top surface (102b) of the integrated capacitor structure (118) is lower than a top surface (102b) of the core structure (102), and the redistribution layer (126) is partially disposed in the core structure (102).

10. The semiconductor package structure (100) as claimed in claim 1, wherein the semiconductor die (132) vertically overlaps the integrated capacitor structure (118).

## Patentansprüche

1. Halbleitergehäusekonstruktion (100, 300, 400, 500, 600, 700, 800), umfassend:
ein Gehäusesubstrat (101), umfassend:
eine Kernkonstruktion (102);
eine integrierte Kondensatorkonstruktion (118), die in der Kernkonstruktion (102) eingebettet ist; und
eine Umverdrahtungsschicht (126), die über der integrierten Kondensatorkonstruktion (118) angeordnet ist, wobei die Umverdrahtungsschicht (126) dielektrische Schichten (122) und Verdrahtungsschichten (124) umfasst; und
einen Halbleiter-Die (130, 132), der über dem Gehäusesubstrat (101) angeordnet und durch die Umverdrahtungsschicht (126) elektrisch mit der integrierten Kondensatorkonstruktion (118) gekoppelt ist;
wobei die integrierte Kondensatorkonstruktion (118) einen ersten Kondensator (114) und einen zweiten Kondensator (116) umfasst, die in einer vertikalen Richtung relativ zu einer unteren Oberfläche (102a) der Kernkonstruktion (102) gestapelt sind;
wobei das Gehäusesubstrat (101) ferner einen isolierenden Füllstoff (120) umfasst, der in der Kernkonstruktion (102) angeordnet ist und einen unteren Abschnitt der integrierten Kondensatorkonstruktion (118) in der vertikalen Richtung umgibt;
**dadurch gekennzeichnet, dass** eine Dicke des isolierenden Füllstoffs (120) geringer als eine Dicke der Kernkonstruktion (102) und geringer als eine Dicke der integrierten Kondensatorkonstruktion (118) ist, um einen oberen Abschnitt der integrierten Kondensatorkonstruktion (118) freizulegen; und
wobei eine der dielektrischen Schichten (122) der Umverdrahtungsschicht (126) den freigelegten oberen Abschnitt der integrierten Kondensatorkonstruktion (118) umgibt und in Kontakt mit dem isolierenden Füllstoff (120) steht.

2. Halbleitergehäusekonstruktion (100) nach Anspruch 1, wobei eine untere Oberfläche der integrierten Kondensatorkonstruktion (118) im Wesentlichen mit der unteren Oberfläche (102a) der Kernkonstruktion (102) bündig ist.

3. Halbleitergehäusekonstruktion (100) nach Anspruch 2, wobei eine obere Oberfläche der integrierten Kondensatorkonstruktion (118) im Wesentlichen mit einer oberen Oberfläche (102b) der Kernkonstruktion (102) bündig ist.

4. Halbleitergehäusekonstruktion (100) nach Anspruch 1, wobei der erste Kondensator (114) und der zweite Kondensator (116) Rücken an Rücken montiert und unter Verwendung einer Klebstoffschicht (115), durch Schmelzbonden oder Hybridbonden verbunden sind.

5. Halbleitergehäusekonstruktion (100) nach Anspruch 4, wobei eine Abmessung des ersten Kondensators (114) größer als eine Abmessung des zweiten Kondensators (116) ist.

6. Halbleitergehäusekonstruktion (100, 600, 700) nach Anspruch 1, wobei der zweite Kondensator (116) über dem ersten Kondensator (114) angeordnet ist und ferner eine Durchkontaktierung umfasst, die den ersten Kondensator (114) elektrisch mit der Umverdrahtungsschicht (126) koppelt.

7. Halbleitergehäusekonstruktion (100, 600, 700) nach Anspruch 6, wobei der erste Kondensator (114) und der zweite Kondensator (116) unter Verwendung von Schmelzbonden oder Hybridbonden verbunden sind.

8. Halbleitergehäusekonstruktion (100) nach Anspruch 1, wobei das Gehäusesubstrat (101) ferner umfasst:
eine zweite Umverdrahtungsschicht (126), die unter der Kernkonstruktion (102) angeordnet ist; und
eine Durchkontaktierung, die sich durch die Kernkonstruktion (102) erstreckt und die Umverdrahtungsschicht (126) elektrisch mit der zweiten Umverdrahtungsschicht (126) koppelt.

9. Halbleitergehäusekonstruktion (100) nach Anspruch 1, wobei eine obere Oberfläche (102b) der integrierten Kondensatorkonstruktion (118) niedriger als eine obere Oberfläche (102b) der Kernkonstruktion (102) ist, und die Umverdrahtungsschicht (126) teilweise in der Kernkonstruktion (102) angeordnet ist.

10. Halbleitergehäusekonstruktion (100) nach Anspruch 1, wobei der Halbleiter-Die (132) die integrierte Kondensatorkonstruktion (118) vertikal überlappt.

## Revendications

1. Structure de boîtier de semi-conducteur (100, 300, 400, 500, 600, 700, 800), comprenant :
un substrat de boîtier (101) comprenant :
une structure centrale (102) ;
une structure de condensateur intégré (118) incorporée dans la structure centrale (102) ; et
une couche de redistribution (126) disposée au-dessus de la structure de condensateur intégré (118), la couche de redistribution (126) comprenant des couches diélectriques (122) et des couches de routage (124) ; et
une puce semi-conductrice (130, 132) disposée au-dessus du substrat de boîtier (101) et couplée électriquement à la structure de condensateur intégré (118) par le biais de la couche de redistribution (126) ;
dans laquelle la structure de condensateur intégré (118) comprend un premier condensateur (114) et un second condensateur (116) qui sont empilés dans une direction verticale par rapport à une surface inférieure (102a) de la structure centrale (102) ;
dans laquelle le substrat de boîtier (101) comprend en outre un remplissage isolant (120) disposé dans la structure centrale (102) et entourant une partie inférieure de la structure de condensateur intégré (118) dans la direction verticale ;
**caractérisée en ce qu'**une épaisseur du remplissage isolant (120) est inférieure à une épaisseur de la structure centrale (102) et inférieure à une épaisseur de la structure de condensateur intégré (118) de manière à exposer une partie supérieure de la structure de condensateur intégré (118) ; et
dans laquelle l'une des couches diélectriques (122) de la couche de redistribution (126) entoure la partie supérieure exposée de la structure de condensateur intégré (118) et est en contact avec le remplissage isolant (120).

2. Structure de boîtier de semi-conducteur (100) selon la revendication 1, dans laquelle une surface inférieure de la structure de condensateur intégré (118) est sensiblement alignée avec la surface inférieure (102a) de la structure centrale (102).

3. Structure de boîtier de semi-conducteur (100) selon la revendication 2, dans laquelle une surface supérieure de la structure de condensateur intégré (118) est sensiblement alignée avec une surface supérieure (102b) de la structure centrale (102).

4. Structure de boîtier de semi-conducteur (100) selon la revendication 1, dans laquelle le premier condensateur (114) et le second condensateur (116) sont assemblés dos à dos et liés à l'aide d'une couche adhésive (115), d'une liaison par fusion ou d'une liaison hybride.

5. Structure de boîtier de semi-conducteur (100) selon la revendication 4, dans laquelle une dimension du premier condensateur (114) est supérieure à une dimension du second condensateur (116).

6. Structure de boîtier de semi-conducteur (100, 600, 700) selon la revendication 1, dans laquelle le second condensateur (116) est disposé au-dessus du premier condensateur (114) et comprenant en outre un trou d'interconnexion traversant couplant électriquement le premier condensateur (114) à la couche de redistribution (126).

7. Structure de boîtier de semi-conducteur (100, 600, 700) selon la revendication 6, dans laquelle le premier condensateur (114) et le second condensateur (116) sont liés à l'aide d'une liaison par fusion ou d'une liaison hybride.

8. Structure de boîtier de semi-conducteur (100) selon la revendication 1, dans laquelle le substrat de boîtier (101) comprend en outre :
une seconde couche de redistribution (126) disposée en dessous de la structure centrale (102) ; et
un trou d'interconnexion traversant s'étendant à travers la structure centrale (102) et couplant électriquement la couche de redistribution (126) à la seconde couche de redistribution (126).

9. Structure de boîtier de semi-conducteur (100) selon la revendication 1, dans laquelle une surface supérieure (102b) de la structure de condensateur intégré (118) est inférieure à une surface supérieure (102b) de la structure centrale (102), et la couche de redistribution (126) est disposée partiellement dans la structure centrale (102).

10. Structure de boîtier de semi-conducteur (100) selon la revendication 1, dans laquelle la puce semi-conductrice (132) chevauche verticalement la structure de condensateur intégré (118).
